# DEMANDE DE BREVET EUROPEEN

(11) **EP 2 615 892 A2**
(43) Date de publication de la demande: **17.07.2013**
(21) Numéro de dépôt: 12350005.0
(22) Date de dépôt: 20.12.2012
(51) Int. Cl.: H05K 5/00

(54) **Dispositif électronique dans un boitier avec clef d'activation**

(30) Priorité: 12.01.2012 FR 1200093
(71) Demandeur: Hydrelis, 62360 Isques (FR)
(72) Inventeur: Sartorius, Thierry, 62152 Hardelot (FR)
(74) Mandataire: Tournel, Jean Louis

(57) **Abrégé**

L'invention a pour objet un dispositif électronique alimenté par une batterie2 le tout étant logé dans un boitier 3, cette électronique étant mise en marche par un moyen 4 de type interrupteur également logé dans le boitier, le contenu du dit boitier composées de deux parties assemblées n'étant plus accessible que par destruction du dit boitier, ce dispositif étant caractérisé en ce que le boitier comporte un puits 5 borgne qui plongeant à l'intérieur dudit boitier accueille une clef 6 portant a son extrémité un moyen 7 actif qui actionne, sans contact , le moyen type interrupteur logé dans le boitier.

## Description

L'invention se rapporte à un dispositif électronique comprenant un boitier contenant une électronique alimentée par une batterie.

Il est courant de protéger une électronique en la logeant dans un boitier et d'équiper cette électronique d'une batterie logée dans le dit boitier.

Dans beaucoup de cas la mise en place de la batterie dans son logement déclenche la mise en fonctionnement de l'électronique. Cette solution est simple et tant que l'électronique du boitier n'a pas besoin d'être utilisée, il ne sert à rien de mettre la pile en place car celle-ci va commencer à se décharger. Bien souvent la pile occupe son logement mais une feuille isolante permet d'isoler électriquement le circuit. Il suffit de tirer sur la feuille pour établir le contact.

Le boitier est donc construit en deux parties séparables permettant l'accès à la batterie pour sa mise en place ou l'extraction de la feuille isolante.

Une autre solution consiste à prévoir un interrupteur sur le boitier que malheureusement tout le monde peut actionner.

Cette solution permet à tout individu la mise en marche ou l'arrêt de l'électronique ce qui est dans certaine situation inapproprié.

Pour éviter cette possibilité, il est connu de faire appel à une commande du type opto-électronique.

Un capteur opto-électronique est monté sur le boitier et peut recevoir un signal optique émis par un appareil émetteur.

Cette solution limite les possibilités d'un intervenant quelconque mais nécessite d'une part une électronique d'interprétation du signal et d'autre part que ce circuit reste en veille pour pouvoir réagir dès que l'on émet un signal optique ce qui consomme du courant.

Il est connu un dispositif US5181744 comprenant une clef d'activation qui venant isoler électriquement deux contacts d'un interrupteur d'un circuit d'alimentation est retirée pour mettre en fonctionnement l'interrupteur. L'électronique n'est pas logée dans une enveloppe complètement étanche car il faut une fenêtre pour le passage de la clef d'activation.

Un autre inconvénient est le besoin de traverser l'enveloppe du boitier pour relier l'interrupteur ou le capteur opto-électronique à cette électronique ce qui constitue une problématique lorsqu'on travaille en milieu humide car ce passage dans l'enveloppe doit alors être traité par au moins un passe câble et plus si besoin.

L'invention vise à apporter une solution.

A cet effet, l'invention se rapporte à un dispositif électronique et sa batterie d'alimentation logés dans un boitier constitué de deux parties assemblées, cette électronique étant mise en marche par un moyen de type interrupteur, le contenu du dit boitier n'étant plus accessible après assemblage des deux parties du dit boitier, ce dispositif étant **caractérisé en ce que** le boitier comporte un puits borgne qui plongeant à l'intérieur dudit boitier accueille une clef portant a son extrémité un moyen magnétique qui actionne, sans contact, le moyen type interrupteur logé dans le boitier déclenchant la mise en marche de l'électronique.

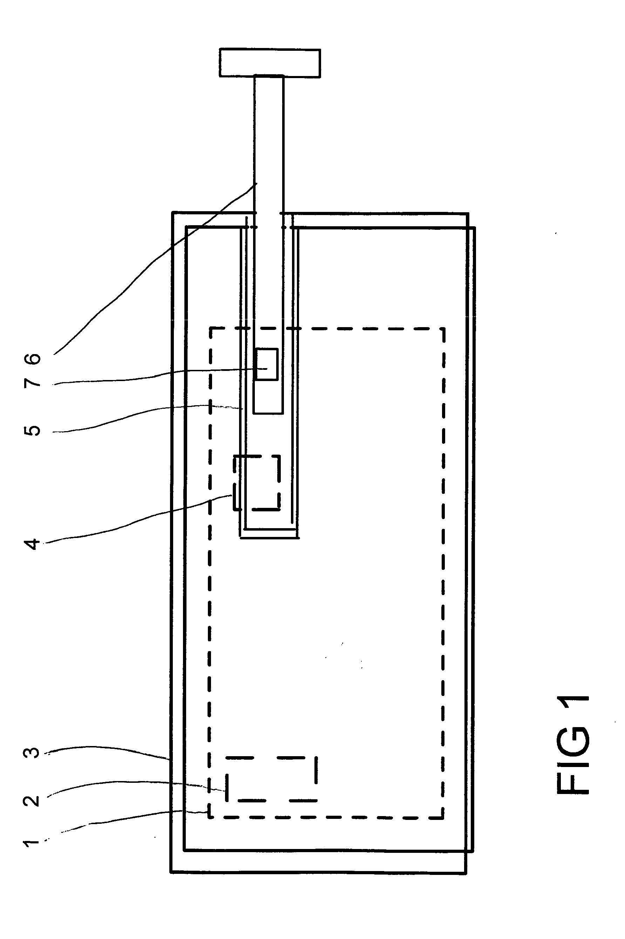

L'invention sera bien comprise à l'aide de la description ci après faite à titre d'exemple non limitatif en regard du dessin qui représente schématiquement un boitier vue en coupe.

En se reportant au dessin, on voit un dispositif 1 électronique alimenté par une batterie 2.

Ce dispositif électronique ainsi que la batterie sont logés dans un boitier 3 qui ne peut plus être ouvert après assemblage de deux parties complémentaires constituant le dit boitier. Ce boitier est constitué initialement de deux parties séparées qui sont assemblées après introduction de l'électronique.

La conséquence de cet assemblage est que la pile ou batterie doit être mise en place avant fermeture du boitier.

Un moyen type interrupteur 4 permet d'intervenir sur le circuit d'alimentation de l'électronique et donc de mettre en fonctionnement l'électronique mais il est logé dans le boitier et n'est donc pas accessible après assemblage des deux parties complémentaires composant ledit boitier.

Avantageusement le boitier comprend un puits 5 borgne qui s'enfonce dans le boitier lequel puits accueille une clef 6 portant à son extrémité un moyen magnétique tel un aimant 7 agissant sur l'interrupteur.

L'utilisation d'un puits permet de venir placer à faible distance d'un composant du circuit un élément actif agissant sans contact sur le dit composant d'un circuit. Par exemple, le moyen actif est un aimant produisant un champ magnétique. Dans le cas du champ magnétique qui agit, le fait de positionner cet élément actif (actionneur) à proximité du moyen d'interruption permet de limiter la puissance du champ magnétique et donc de limiter l'influence de celui-ci sur des dispositifs qui seraient proches.

Sur la représentation, la clef est ici partiellement engagée dans le puits.

Plus précisément l'interrupteur utilisé est du type ILS ( interrupteur à lame souple) et on peut le monter selon deux solutions.

Une première solution consiste à enclencher le système d'alimentation en introduisant la clef dans le puits.

La deuxième solution consiste à mettre en marche l'électronique dès le retrait de la clef aimantée. Dans ce cas, lorsque la clef est en place, elle agit en maintenant ouvert l'interrupteur qui dès qu'il n'est plus soumis au champ magnétique bascule en une position établissant le passage du courant ou une autre solution consiste, lors du retrait de la clef à rapprocher l'aimant du contacteur et en passant devant de contacteur à fermer le circuit d'alimentation.

Le circuit comprendra éventuellement un circuit rendant inopérationnelle une action inverse sur l'interrupteur.

Le dispositif électronique comprend par exemple un émetteur sans fil.

On préserve également l'étanchéité du boitier. En effet, le boitier reste clos tout en permettant d'agir sur un composant avec un moyen actif qui doit être positionné à proximité dudit composant.

## Revendications

1. Dispositif électronique alimenté par une batterie (2) lesquels dispositif électronique et batterie sont logés dans un boitier (3), cette électronique étant mise en marche par un moyen (4) de type interrupteur, le contenu du dit boitier n'étant plus accessible après assemblage des deux parties complémentaires composant le dit boitier, ce dispositif étant **caractérisé en ce que** le boitier comporte un puits (5) borgne qui plongeant à l'intérieur dudit boitier accueille une clef (6) portant a son extrémité un aimant (7) produisant un champ magnétique qui actionne, sans contact, le moyen 4 type interrupteur logé dans le boitier.

2. Dispositif électronique selon la revendication 1 **caractérisé en ce que** le moyen (4) type interrupteur est un interrupteur à lame souple.

3. Dispositif électronique selon la revendication 1 ou 2 **caractérisé en ce que** le dispositif électronique comprend un circuit rendant inopérationnelle une action inverse sur l'interrupteur.

4. Dispositif électronique selon l'une quelconque des revendications précédentes **caractérisé en ce que** l'électronique comprend un émetteur sans fil.
